(19) Europäisches Patentamt
European Patent Office
Office européen des brevets

(11) EP 3 905 531 A1

(12) EUROPEAN PATENT APPLICATION

(43) Date of publication:
03.11.2021 Bulletin 2021/44

(51) Int Cl.:
*H03M 1/10 (2006.01)* *H03M 1/46 (2006.01)*

(21) Application number: 20172006.7

(22) Date of filing: 29.04.2020

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(71) Applicant: IMEC VZW
3001 Leuven (BE)

(72) Inventors:
- Martens, Ewout
  3001 Leuven (BE)
- Dermit, Davide
  3001 Leuven (BE)
- Craninckx, Jan
  3001 Leuven (BE)

(74) Representative: Körfer, Thomas et al
Mitscherlich PartmbB
Patent- und Rechtsanwälte
Sonnenstrasse 33
80331 München (DE)

# (54) ADVANCED SUCCESSIVE APPROXIMATION REGISTER ANALOG-TO-DIGITAL CONVERTER AND CORRESPONDING METHOD

(57) An advanced successive approximation register analog-to-digital converter (10) is provided. Said advanced successive approximation register analog-to-digital converter (10) comprises a digital-to-analog converter (11), a successive approximation register (12), a comparator (13), and a threshold voltage determining unit (14). In this context, the threshold voltage determining unit (14) is configured to dynamically determine the respective threshold voltage of the comparator (13) on the basis of the respective input signal of the digital-to-analog converter (11) or the respective output signal of the comparator (13).

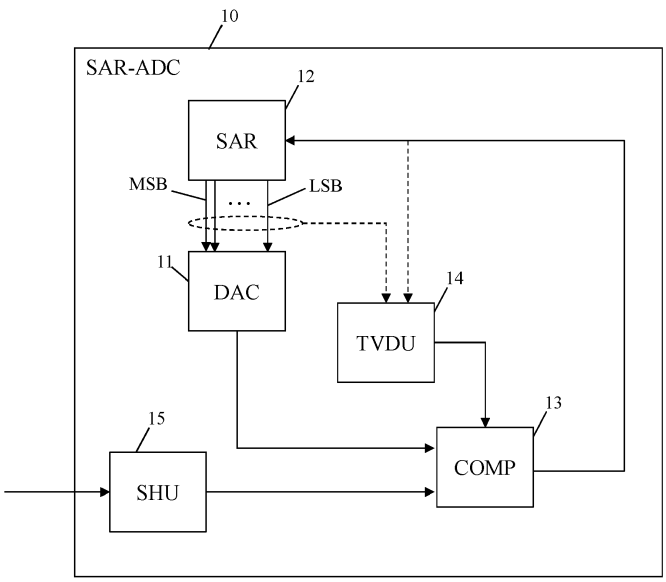


Fig. 1

EP 3 905 531 A1

## Description

The invention relates to an advanced successive approximation register analog-to-digital converter and a method for compensating a mismatch of a digital-to-analog converter of a successive approximation register analog-to-digital converter.

Generally, in times of an increasing number of applications employing a variety of electrical circuits, there is a growing need of an advanced successive approximation register analog-to-digital converter and a method for compensating a mismatch of a digital-to-analog converter of a successive approximation register analog-to-digital converter, which are exemplarily used for performing measurements with respect to such applications in order to verify their correct functioning in a particularly accurate and efficient manner.

US 2019/0131991 A1 shows an analog-to-digital converter including a controller, a comparator, and a switch capacitor array. The comparator has a first input terminal, a second input terminal, and an output terminal. The comparator is coupled to the controller. The switch capacitor array is coupled to the controller. The switch capacitor array includes a plurality of switch capacitor groups. The first input terminal of the comparator receives a first voltage quantity. The controller operates the switch capacitor groups, so as to provide a second voltage quantity to the second input terminal of the comparator by one of the switch capacitor groups and provide a compensation voltage quantity to the second input terminal of the comparator by at least another one of the switch capacitor groups. The comparator compares a voltage value received by the first input terminal and a voltage value received by the second input terminal, and outputs a voltage comparison result to the controller. If the controller determines that a voltage quantity provided to the second input terminal approximates to a charge quantity provided to the first input terminal based on the voltage comparison result, the controller records a calibration charge quantity in a lookup table stored by the controller. The calibration voltage quantity is equal to the compensation voltage quantity minus or plus a voltage quantity provided by a unit capacitance.

As it can be seen, a compensation is exclusively performed with respect to the digital-to-analog converter being embodied in the form of the switch capacitor array, which disadvantageously leads to a limited accuracy and a reduced efficiency of the respective analog-to-digital converter comprising said digital-to-analog converter.

Accordingly, there is an object to provide an advanced successive approximation register analog-to-digital converter and a method for compensating a mismatch of a digital-to-analog converter of a successive approximation register analog-to-digital converter, thereby ensuring a particularly high accuracy and efficiency.

This object is solved by the features of the first independent claim for an advanced successive approximation register analog-to-digital converter and the features of the second independent claim for a method for compensating a mismatch of a digital-to-analog converter of a successive approximation register analog-to-digital converter. The dependent claims contain further developments.

According to a first aspect of the invention, an advanced successive approximation register analog-to-digital converter is provided. The advanced successive approximation register analog-to-digital converter comprises a digital-to-analog converter, a successive approximation register, a comparator, and a threshold voltage determining unit. In this context, the threshold voltage determining unit is configured to dynamically determine, especially to set, the respective threshold voltage of the comparator on the basis of the respective input signal of the digital-to-analog converter or the respective output signal of the comparator. Advantageously, both a particularly high accuracy and a particularly high efficiency are ensured.

Further advantageously, additionally or alternatively, the threshold voltage determining unit may be configured to dynamically determine, especially to set, the respective threshold voltage of the comparator on the basis of the respective output signals during the previous comparisons for the current sample.

According to a first preferred implementation form of the first aspect of the invention, the advanced successive approximation register analog-to-digital converter further comprises a sample-and-hold unit. In this context, the sample-and-hold unit is configured to acquire the respective input signal of the advanced successive approximation register analog-to-digital converter. Advantageously, the sample-and-hold unit may comprise but is not limited to a sampling switch connected to the top plate of the digital-to-analog converter of the analog-to-digital converter.

According to a second preferred implementation form of the first aspect of the invention, the digital-to-analog converter is configured to provide an analog signal for the comparator on the basis of the respective output signal of the successive approximation register.

According to a further preferred implementation form of the first aspect of the invention, the successive approximation register is configured to provide an approximate digital representation of the respective input signal of the advanced successive approximation register analog-to-digital converter for the digital-to-analog converter.

According to a further preferred implementation form of the first aspect of the invention, the comparator is configured to compare, preferably the difference between, the respective input signal of the advanced successive approximation register analog-to-digital converter and the respective output signal of the digital-to-analog converter with the respective threshold voltage of the comparator, and to provide the corresponding result of the comparison for the successive approximation register.

According to a further preferred implementation form of the first aspect of the invention, the respective input signal of the comparator comprises or is a differential signal.

According to a further preferred implementation form of the first aspect of the invention, the differential signal is symmetric with respect to a certain value, preferably zero. Advantageously, for example, complexity can further be reduced, thereby increasing both accuracy and efficiency.

According to a further preferred implementation form of the first aspect of the invention, the dynamic determination of the respective threshold voltage of the comparator comprises or is an iterative determination. Advantageously, for instance, accuracy can further be increased.

According to a further preferred implementation form of the first aspect of the invention, especially in a first iteration step, preferably when the input signal is directly brought to the respective top plate of the digital-to-analog converter, the threshold voltage determining unit is configured to set the respective threshold voltage of the comparator to zero or the offset of the comparator especially caused by mismatch. Advantageously, for example, not only accuracy but also efficiency can further be increased.

According to a further preferred implementation form of the first aspect of the invention, especially in a second iteration step, the threshold voltage determining unit is configured to set, preferably to increase or decrease, the respective threshold voltage of the comparator, preferably with an amount, based on, preferably the respective mismatch of, the most significant bit of the digital-to-analog converter. Advantageously, for instance, both inaccuracies and inefficiencies can further be reduced.

According to a further preferred implementation form of the first aspect of the invention, especially in a third iteration step, the threshold voltage determining unit is configured to set, preferably to increase or decrease, the respective threshold voltage of the comparator, preferably with an amount, based on, preferably the mismatch of, one bit less than the respective most significant bit of the digital-to-analog converter. Advantageously, for example, efficiency and accuracy can further be increased.

According to a further preferred implementation form of the first aspect of the invention, especially in the case that further iteration steps are required, in each further step, the threshold voltage determining unit is configured to set, preferably increase or decrease, the respective threshold voltage of the comparator, preferably by an amount, based on, preferably the mismatch of, the respective lowest bit of the previous step of the digital-to-analog converter. Advantageously, for instance, accuracy can be increased in a particularly efficient manner.

According to a second aspect of the invention, a method for compensating a mismatch of a digital-to-analog converter of a successive approximation register analog-to-digital converter is provided. The method comprises the step of dynamically determining the respective threshold voltage of a comparator of the successive approximation register analog-to-digital converter on the basis of the respective input signal of the digital-to-analog converter or the respective output signal of the comparator. Advantageously, both a particularly high accuracy and a particularly high efficiency are ensured.

According to a first preferred implementation form of the second aspect of the invention, the dynamic determination of the respective threshold voltage of the comparator comprises or is an iterative determination. Advantageously, for instance, accuracy can further be increased.

According to a second preferred implementation form of the second aspect of the invention, the method further comprises the step of, especially as a first iteration step, setting the respective threshold voltage of the comparator to zero or to the offset of the comparator especially caused by mismatch.

In addition to this or as an alternative, the method further comprises the step of, especially as a second iteration step, setting , preferably increasing or decreasing, the respective threshold voltage of the comparator, preferably by an amount, based on, preferably the mismatch of, the respective most significant bit of the digital-to-analog converter. Advantageously, for instance, both inaccuracies and inefficiencies can further be reduced.

Further additionally or further alternatively, the method further comprises the step of, especially as a third iteration step, setting, preferably increasing or decreasing, the respective threshold voltage of the comparator, preferably by an amount, based on, preferably the mismatch of, one bit less than the respective most significant bit of the digital-to-analog converter. Advantageously, for example, efficiency and accuracy can further be increased.

In further addition to this or as a further alternative, the method further comprises the step of, especially in the case that further iteration steps are required, as each further step, setting, preferably increasing or decreasing, the respective threshold voltage of the comparator, preferably by an amount, based on, preferably the mismatch of, the respective lowest bit of the previous step of the digital-to-analog converter. Advantageously, for instance, accuracy can be increased in a particularly efficient manner.

Exemplary embodiments of the invention are now further explained with respect to the drawings by way of example only, and not for limitation. In the drawings:

Fig. 1 shows an exemplary embodiment of an inventive advanced successive approximation register analog-to-digital converter;

Fig. 2 shows an exemplary differential (N+1)-bit successive approximation register analog-to-digital converter without digital-to-analog converter mismatch compensation;

Fig. 3 shows exemplary top plate voltages of the respective digital-to-analog converter in an ideal case (dotted line) and with mismatch (solid line);

Fig. 4 shows the exemplary differential N-bit successive approximation register analog-to-digital converter of Fig. 2 with an additional signal-dependent comparator offset according to the invention;

Fig. 5A shows an exemplary improvement of the effective number of bits with the aid of the invention;

Fig. 5B shows an exemplary improvement of the spurious-free dynamic range with the aid of the invention;

Fig. 6 shows an exemplary reduction of the number of missing codes with the aid of the invention; and

Fig. 7 shows a flow chart of an embodiment of the inventive method for compensating a mismatch of a digital-to-analog converter of a successive approximation register analog-to-digital converter.

With respect to Fig. 1, a block diagram of an exemplary embodiment of an inventive advanced successive approximation register analog-to-digital converter (SAR-ADC) 10 is shown.

According to Fig. 1, the advanced successive approximation register analog-to-digital converter 10 comprises a digital-to-analog converter 11, a successive approximation register 12, a comparator 13, and a threshold voltage determining unit 14. In this context, the threshold voltage determining unit 14 is configured to dynamically determine the respective threshold voltage of the comparator 13 on the basis of the respective input signal of the digital-to-analog converter 11 or the respective output signal of the comparator 13.

It might be particularly advantageous if the threshold voltage determining unit 14 firstly determines the threshold based on the respective output signal, especially the respective previous output signal, of the comparator 13 and then increases or decreases the respective threshold voltage for the new comparison by an amount based on the mismatch of the digital-to-analog converter capacitors that are switched based on the output of the comparator 13.

As it can further be seen from Fig. 1, the advanced successive approximation register analog-to-digital converter 10 further comprises a sample-and-hold unit 15.

In this context, the sample-and-hold unit 15 is configured to acquire the respective input signal of the advanced successive approximation register analog-to-digital converter 10.

It might be particularly advantageous if the digital-to-analog converter 11 is configured to provide an analog signal for the comparator 13 on the basis of the respective output signal of the successive approximation register 12. It is further noted that the successive approximation register 12 may preferably be configured to provide an approximate digital representation of the respective input signal of the advanced successive approximation register analog-to-digital converter 10 for the digital-to-analog converter 11.

Furthermore, the comparator 13 may especially be configured to compare the difference between the respective input signal of the advanced successive approximation register analog-to-digital converter 10 and the respective output signal of the digital-to-analog converter 11 with the respective threshold voltage of the comparator 13, and to provide the corresponding result of the comparison for the successive approximation register 12. Moreover, it might be particularly advantageous if the respective input signal of the comparator 13 comprises or is a differential signal.

It is further noted that the dynamic determination of the respective threshold voltage of the comparator 13 may preferably comprise or be an iterative determination. With respect to said iterative determination, especially in a first iteration step, the threshold voltage determining unit 14 may preferably be configured to set the respective threshold voltage of the comparator 13 to zero or to an offset of the comparator 13.

In addition to this or as an alternative, especially in a second iteration step, the threshold voltage determining unit 14 may preferably be configured to increase or decrease the respective threshold voltage of the comparator 13 by an amount based on switching the respective most significant bit with a mismatch of the digital-to-analog converter 11.

Further additionally or further alternatively, especially in a third iteration step, the threshold voltage determining unit 14 may preferably be configured to increase or decrease the respective threshold voltage of the comparator 13 by an amount based on switching one bit less than the respective most significant bit with a mismatch of the digital-to-analog converter 11.

In further addition to this or as a further alternative, especially in the case that further iteration steps are required, in each further step, the threshold voltage determining unit 14 may preferably be configured to increase or decrease the threshold of comparator 13 by an amount based on switching one bit less than the respective lowest bit of the previous step with a mismatch of the digital-to-analog converter 11.

Now, with respect to Fig. 2, an exemplary differential (N+1)-bit successive approximation register analog-to-digital converter 20 is shown. In this context, the respective input signal is sampled onto a differential digital-to-analog converter 21 of said (N+1)-bit successive approximation register analog-to-digital converter 20, wherein a mismatch in the digital-to-analog converter 21 is not compensated. As it can further be seen, the (N+1)-bit successive approximation register analog-to-digital converter 20 additionally comprises a successive approximation register 22 and a comparator 23.

It is noted that each of the two differential paths of the digital-to-analog converter 21 comprises N capacitors. In this context, the capacitance value of the capacitor for the most significant bit (MSB) is $2^{N-1}$ times the capacitance value of the capacitor for the least significant bit (LSB), whereas the respective capacitance value is halved for each bit between the most and the least significant bit (starting from the MSB and going to the LSB).

In any implementation, especially due to mismatch effects during the fabrication of the device, these capacitance values may slightly differ from the designed values. Hence, the output voltage of the digital-to-analog converter may differ from the intended one, which may cause errors in the analog-to-digital conversion.

According to the invention, said mismatch in the digital-to-analog converter 21 is to be compensated especially with a signal-dependent offset in the comparator 23, which will be explained in more detail in the following. For the sake of completeness, it is primarily demonstrated what happens if said mismatch is not compensated with the aid of the inventive threshold voltage determination or the signal-dependent offset, respectively.

In this context, after the respective sampling operation which puts a voltage $V_{sampled}$ on the top plate of the digital-to-analog converter, the comparator 23 (without offset) decides on the most significant bit according to the following equation:

$$MSB = b_{N-1} = \begin{cases} 0 & if\ V_{sampled} < 0, \\ 1 & if\ V_{sampled} > 0. \end{cases} \qquad (1)$$

Then, the digital-to-analog converter 21 generates a new signal on its top plate as illustrated by Fig. 3 showing exemplary top plate voltages of the respective digital-to-analog converter 21 especially versus the respective sampled input voltage $V_{sampled}$ in an ideal case (dotted line) and with mismatch (solid line).

As it can be seen from said Fig. 3, with mismatch in the digital-to-analog converter 21, an error ε0 or ε1 is made depending on the value of $b_{N-1}$. The top plate voltage then becomes:

$$V_{top,1} = V_{sample} + (1 - 2b_{N-1}) \cdot \overline{V}_{fb,MSB} + \varepsilon(b_{N-1}) = \overline{V}_{top,1} + \varepsilon_{MSB}(b_{N-1}), \qquad (2)$$

In this context, $\overline{V}_{fb,MSB}$ denotes the ideal MSB feedback step, $\overline{V}_{top,1}$ denotes the ideal top plate value, and $\varepsilon_{MSB}(b_{N-1})$ denotes the error due to the MSB switching with mismatch of the digital-to-analog converter 21:

$$\varepsilon_{MSB}(b_{N-1}) = \begin{cases} \varepsilon_0 & if\ b_{N-1} = 0, \\ \varepsilon_1 & if\ b_{N-1} = 1. \end{cases} \qquad (3)$$

For an ideal converter, the next bit is determined by a comparator without offset:

$$b_{N-2} = \begin{cases} 0 & if\ \overline{V}_{top} < 0, \\ 1 & if\ \overline{V}_{top} > 0. \end{cases} \qquad (4)$$

In the case of mismatch, this would cause errors in the analog-to-digital conversion, since the actual $V_{top}$ especially differs from the ideal $V_{top}$.

However, from equation (2) above, this comparison gives the same result as

$$b_{N-2} = \begin{cases} 0 & if\ V_{top} < \varepsilon_{MSB}(b_{N-1}), \\ 1 & if\ V_{top} > \varepsilon_{MSB}(b_{N-1}). \end{cases} \quad (5)$$

So, if the comparator has a built-in offset of $\varepsilon_{MSB}(b_{N-1})$, the mismatch of the digital-to-analog converter 21 is compensated.

This leads to the differential (N+1)-bit successive approximation register analog-to-digital converter 30 with an additional signal-dependent comparator offset according to the invention as shown in Fig. 4, which is based on Fig. 2. In this context, it is noted that Fig. 4 especially differs from Fig. 2 in that Fig. 4 additionally comprises an inventive threshold voltage determining unit, which is exemplarily embodied as the threshold voltage (Vth) selector 24.

Each time the digital-to-analog converter 21 executes a feedback, the new value on the top plate can be written as:

$$V_{top,k} = V_{top,k-1} + (1 - 2b_{N-k}) \cdot \overline{V}_{fb,MSB-k+1} + \varepsilon(b_{N-k}) \quad (6a)$$

$$= \overline{V}_{top,k} + \varepsilon_{MSB}(b_{N-1}) + \varepsilon_{MSB-1}(b_{N-2}) + \cdots + \varepsilon_{MSB-k+1}(b_{N-k}) \quad (6b)$$

Hence, to obtain the correct result from the comparators, the offset Vth (threshold voltage) should be set as:

step 0: $Vth = 0$
step 1: $Vth = \varepsilon_{MSB}(b_{N-1})$
step 2: $Vth = \varepsilon_{MSB}(b_{N-1}) + \varepsilon_{MSB-1}(b_{N-2})$
...
step k: $Vth = \varepsilon_{MSB}(b_{N-1}) + \varepsilon_{MSB-1}(b_{N-2}) + \cdots + \varepsilon_{MSB-k+1}(b_{N-k})$

The amounts by which the threshold determining unit should increase or decrease the threshold voltage or then as follows:

step 0: $\Delta Vth = 0$
step 1: $\Delta Vth = \varepsilon_{MSB}(b_{N-1})$
step 2: $\Delta Vth = \varepsilon_{MSB-1}(b_{N-2})$
...
step k: $\Delta Vth = \varepsilon_{MSB-k+1}(b_{N-k})$

Assuming the errors become smaller, when going deeper into the conversion, after some steps the threshold can be kept constant to continue the conversion.

It is further noted that it might be particularly advantageous if the offset, of the comparator is added as follows:

step 0: $\Delta Vth = V_{offset}$
step 1: $\Delta Vth = \varepsilon_{MSB}(b_{N-1})$
step 2: $\Delta Vth = \varepsilon_{MSB-1}(b_{N-2})$
...
step k: $\Delta Vth = \varepsilon_{MSB-k+1}(b_{N-k})$

Furthermore, Fig. 5A and Fig. 5B show the effect on the effective number of bits (ENOB) and spurious-free dynamic range (SFDR) for a 12-bit SAR for 5000 Monte-Carlo points with random mismatch. The x-axis contains the number of comparisons with signal-dependent threshold. As described above, the remaining comparisons are done with the same threshold as the last one.

Moreover, in Fig. 6, the number of missing codes is exemplarily plotted. With the aid of the invention, it drops to zero after enabling the signal-dependent offset especially for enough comparisons.

It is further noted that the invention also provides the following major benefits:
The size of the digital-to-analog converter 21 can be made much smaller than required by the matching. This saves digital-to-analog converter area as well as power drawn from the reference. Also, settling becomes faster due to smaller RC time constants.

Further advantageously, the inventive successive approximation register analog-to-digital converter starts from a basic successive approximation register without changing the switching scheme or requiring oversampling.

As a further advantage, no digital post-processing is required. Accuracy is set by the resolution of the threshold voltage tuning especially in the analog domain, which requires less complexity to achieve the same level of accuracy.

Further advantageously, the offset of the comparator 23 is easily tuned within less than 1 LSB via e.g., nonlinear capacitors exemplarily made with metal oxide semiconductor capacitors (MOSCAPs). Tuning via the digital-to-analog converter 21 requires very small linear units. For instance, a 0.2fF unit is needed on a 1pF to generate 0.2mV compensation with Vdd = 1V. Whereas 0.2fF is complicated to make, 0.2mV compensation on the offset is rather straightforward.

As a further major advantage, nonlinear tuning of the threshold voltage can be used to linearize the digital-to-analog converter 21.

Finally, Fig. 7 shows a flow chart of an embodiment of the inventive method for compensating a mismatch of a digital-to-analog converter of a successive approximation register analog-to-digital converter.

In a first step 100, the respective threshold voltage of a comparator of the successive approximation register analog-to-digital converter is dynamically determined on the basis of the respective input signal of the digital-to-analog converter or the respective output signal of the comparator. Then, in a second step 101 being especially an optional step, the dynamic determination of the respective threshold voltage of the comparator is defined as an iterative determination.

It is noted that it might be particularly advantageous if the method further comprises the steps of, especially as a first iteration step, setting the respective threshold voltage of the comparator to zero or to the offset of the comparator. In addition to this or as an alternative, especially as a second iteration step, the method may further comprise the step of increasing or decreasing the respective threshold voltage of the comparator by an amount based on switching the respective most significant bit with a mismatch of the digital-to-analog converter.

Further additionally or further alternatively, especially as a third iteration step, the method may further comprise the step of increasing or decreasing the respective threshold voltage of the comparator by an amount based on switching one bit less than the respective most significant bit with a mismatch of the digital-to-analog converter.

In further addition to this or as a further alternative, the method may further comprise the step of, especially in the case that further iteration steps are required, as each further step, increase or decrease the threshold by an amount based on switching one bit less than the respective lowest bit of the previous step with a mismatch of the digital-to-analog converter.

While various embodiments of the present invention have been described above, it should be understood that they have been presented by way of example only, and not limitation. Numerous changes to the disclosed embodiments can be made in accordance with the disclosure herein without departing from the spirit or scope of the invention. Thus, the breadth and scope of the present invention should not be limited by any of the above described embodiments. Rather, the scope of the invention should be defined in accordance with the following claims and their equivalents.

Although the invention has been illustrated and described with respect to one or more implementations, equivalent alterations and modifications will occur to others skilled in the art upon the reading and understanding of this specification and the annexed drawings. In addition, while a particular feature of the invention may have been disclosed with respect to only one of several implementations, such feature may be combined with one or more other features of the other implementations as may be desired and advantageous for any given or particular application.

## Claims

1. An advanced successive approximation register analog-to-digital converter (10, 30) comprising:

   a digital-to-analog converter (11, 21),
   a successive approximation register (12, 22),
   a comparator (13, 23), and
   a threshold voltage determining unit (14, 24),

   wherein the threshold voltage determining unit (14, 24) is configured to dynamically determine the respective threshold voltage of the comparator (13, 23) on the basis of the respective input signal of the digital-to-analog converter (11, 21) or the respective output signal of the comparator (13, 23).

2. The advanced successive approximation register analog-to-digital converter (10, 30) according to claim 1, wherein the advanced successive approximation register analog-to-digital converter (10, 30) further comprises a sample-and-hold unit (15),
   wherein the sample-and-hold unit (15) is configured to acquire the respective input signal of the advanced successive approximation register analog-to-digital converter (10, 30).

3. The advanced successive approximation register analog-to-digital converter (10, 30) according to claim 1 or 2, wherein the digital-to-analog converter (11, 21) is configured to provide an analog signal for the comparator (13, 23) on the basis of the respective output signal of the successive approximation register (12, 22).

4. The advanced successive approximation register analog-to-digital converter (10, 20) according to any of the claims 1 to 3,
wherein the successive approximation register (12, 22) is configured to provide an approximate digital representation of the respective input signal of the advanced successive approximation register analog-to-digital converter (10, 30) for the digital-to-analog converter (11, 21).

5. The advanced successive approximation register analog-to-digital converter (10, 30) according to any of the claims 1 to 4,
wherein the comparator (13, 23) is configured to compare, preferably the difference between, the respective input signal of the advanced successive approximation register analog-to-digital converter (10, 30) and the respective output signal of the digital-to-analog converter (11, 21) with the respective threshold voltage of the comparator (13, 23), and to provide the corresponding result of the comparison for the successive approximation register (12, 22).

6. The advanced successive approximation register analog-to-digital converter (10, 30) according to any of the claims 1 to 5,
wherein the respective input signal of the comparator (13, 23) comprises or is a differential signal.

7. The advanced successive approximation register analog-to-digital converter (10, 30) according to claim 6, wherein the differential signal is symmetric with respect to a certain value, preferably zero.

8. The advanced successive approximation register analog-to-digital converter (10, 30) according to any of the claims 1 to 7,
wherein the dynamic determination of the respective threshold voltage of the comparator (13, 23) comprises or is an iterative determination.

9. The advanced successive approximation register analog-to-digital converter (10, 30) according to claim 8, wherein especially in a first iteration step, preferably when the input signal is directly brought to the respective top plate of the digital-to-analog converter, the threshold voltage determining unit (14, 24) is configured to set the respective threshold voltage of the comparator (13, 23) to zero or to the offset of the comparator (13, 23) especially caused by mismatch.

10. The advanced successive approximation register analog-to-digital converter (10, 30) according to claim 8 or 9, wherein especially in a second iteration step, the threshold voltage determining unit (14, 24) is configured to set, preferably to increase or decrease, the respective threshold voltage of the comparator (13, 23), preferably by an amount, based on, preferably the respective mismatch of, the most significant bit of the digital-to-analog converter 11, 21).

11. The advanced successive approximation register analog-to-digital converter (10, 30) according to any of the claims 8 to 10,
wherein especially in a third iteration step, the threshold voltage determining unit (14, 24) is configured to set, preferably to increase or decrease, the respective threshold voltage of the comparator (13, 23), preferably with an amount, based on, preferably the mismatch of, one bit less than the respective most significant bit of the digital-to-analog converter (11, 21).

12. The advanced successive approximation register analog-to-digital converter (10, 30) according to claim 11, wherein especially in the case that further iteration steps are required, in each further step, the threshold voltage determining unit (14, 24) is configured to increase or decrease the respective threshold voltage by an amount based on the mismatch of the respective lowest bit of the previous step of the digital-to-analog converter (11, 21).

13. A method for compensating a mismatch of a digital-to-analog converter (11, 21) of a successive approximation register analog-to-digital converter (10, 20, 30), the method comprising the step of:
dynamically determining the respective threshold voltage of a comparator (13, 23) of the successive approximation register analog-to-digital converter (10, 20, 30) on the basis of the respective input signal of the digital-to-analog converter (11, 21) or the respective output signal of the comparator (13, 23).

**14.** The method according to claim 13, wherein the dynamic determination of the respective threshold voltage of the comparator (13, 23) comprises or is an iterative determination.

**15.** The method according to claim 14, wherein the method further comprises the steps of:

especially as a first iteration step, setting the respective threshold voltage of the comparator (13, 23) to zero or to the offset of the comparator (13, 23) especially caused by mismatch, and/or
especially as a second iteration step, setting, preferably increasing or decreasing, the respective threshold voltage of the comparator (13, 23), preferably by an amount, based on, preferably the mismatch of, the respective most significant bit of the digital-to-analog converter (11, 21), and/or
especially as a third iteration step, setting, preferably increasing or decreasing, the respective threshold voltage of the comparator (13, 23), preferably by an amount, based on, preferably the mismatch of, one bit less than the respective most significant bit of the digital-to-analog converter (11, 21), and/or
especially in the case that further iteration steps are required, as each further step, setting, preferably increasing or decreasing, the respective threshold voltage of the comparator (13, 23), preferably by an amount, based on, preferably the mismatch of, the respective lowest bit of the previous step of the digital-to-analog converter (11, 21).

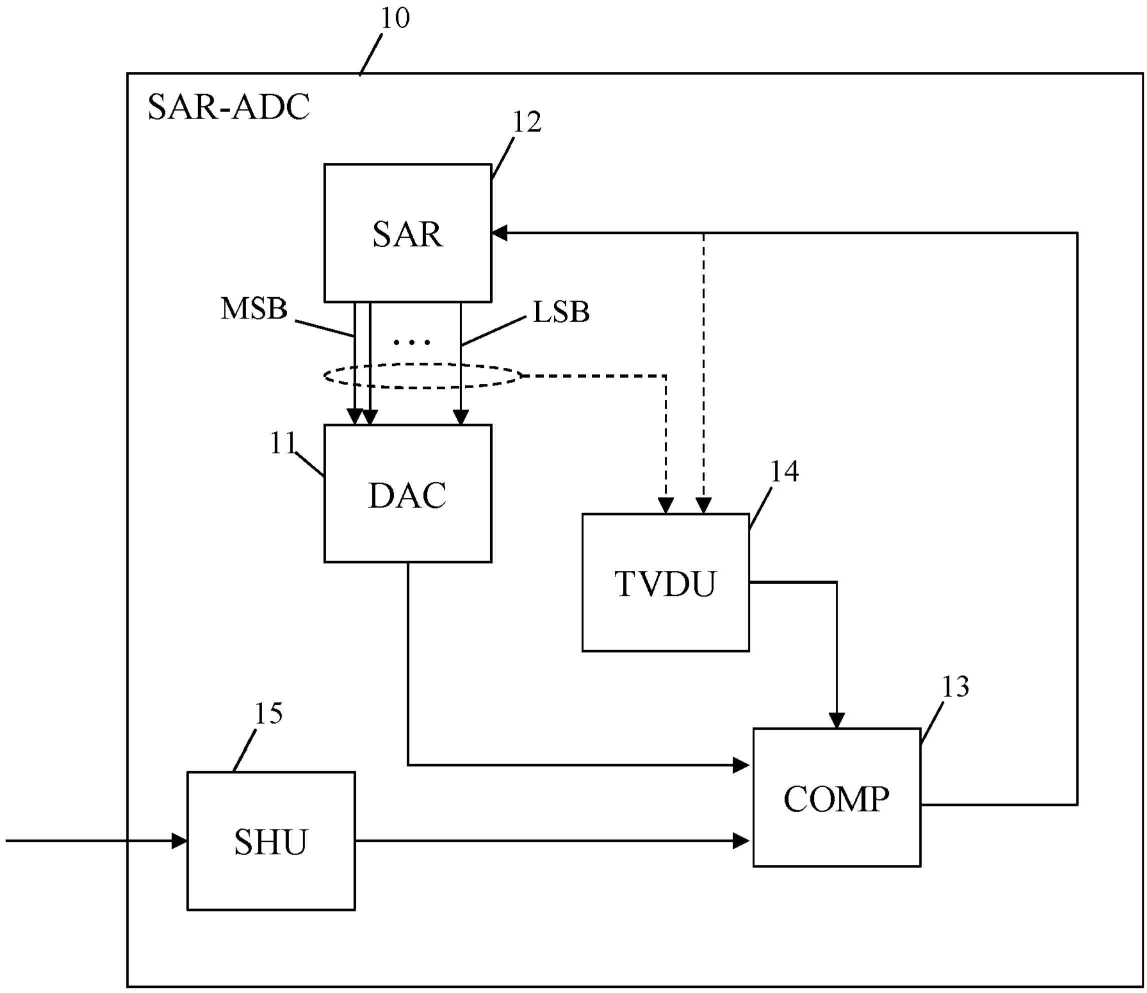


Fig. 1

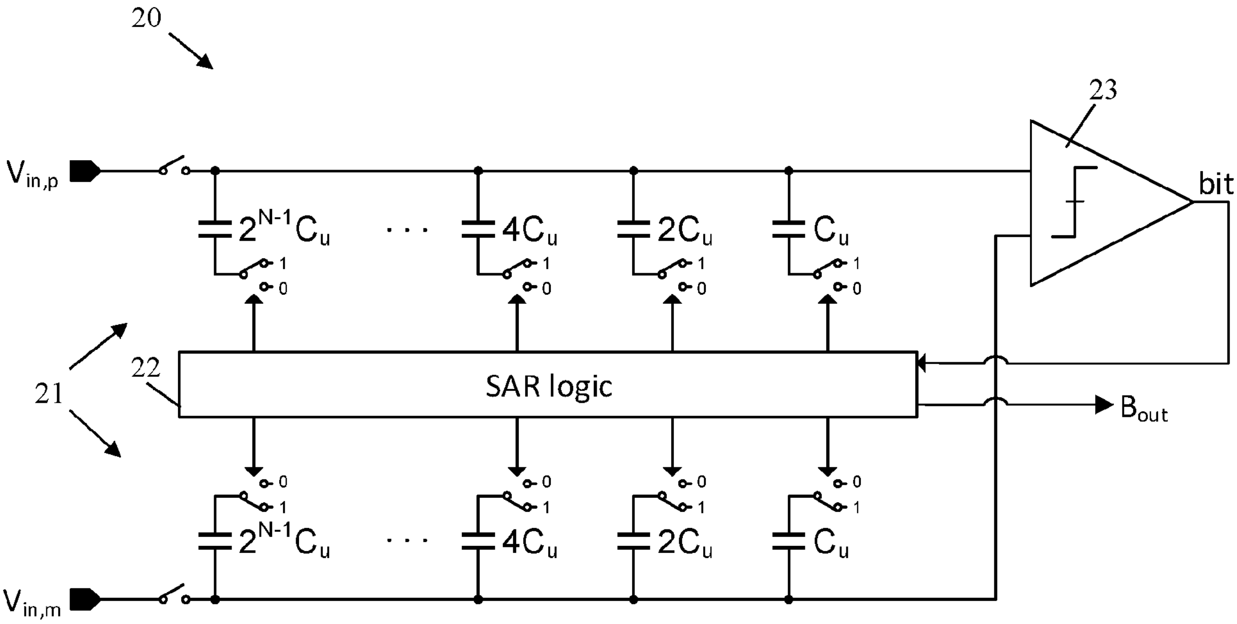
20
23
$V_{in,p}$
$2^{N-1}C_u$
4$C_u$
2$C_u$
$C_u$
bit
21
22
SAR logic
$B_{out}$
$V_{in,m}$

Fig. 2

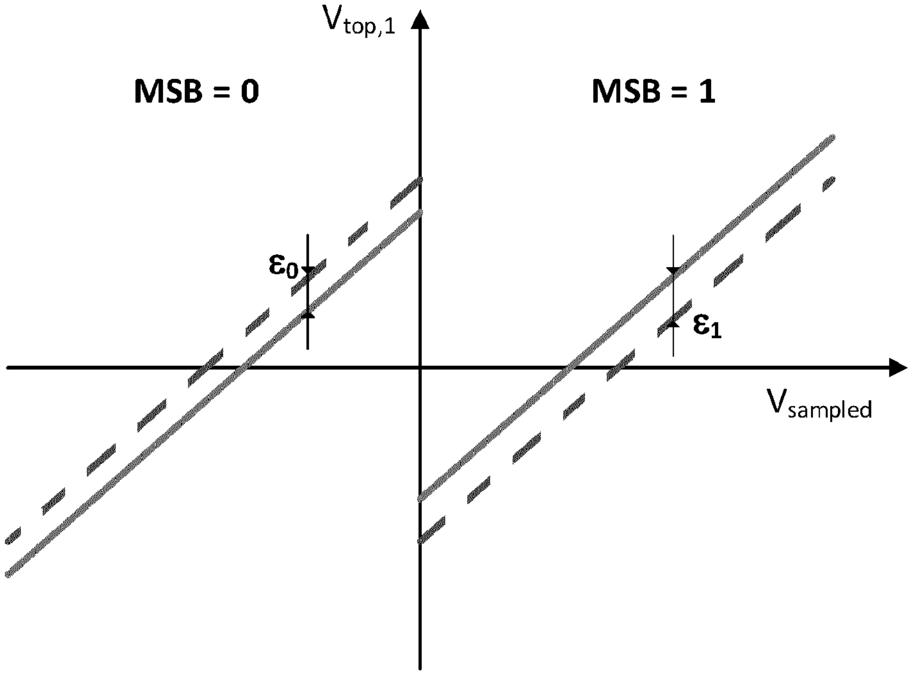
$V_{top,1}$
MSB = 0
MSB = 1
$\varepsilon_0$
$\varepsilon_1$
$V_{sampled}$

Fig. 3

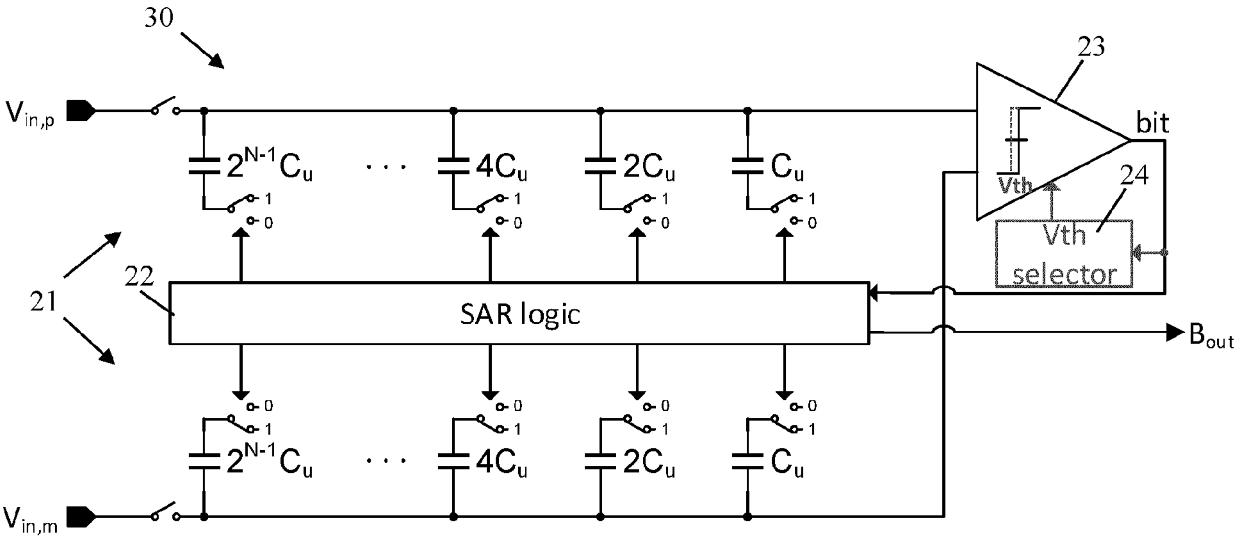
30
23
$V_{in,p}$
$2^{N-1}C_u$
4$C_u$
2$C_u$
$C_u$
bit
Vth
24
Vth selector
21
22
SAR logic
$B_{out}$
$V_{in,m}$

Fig. 4

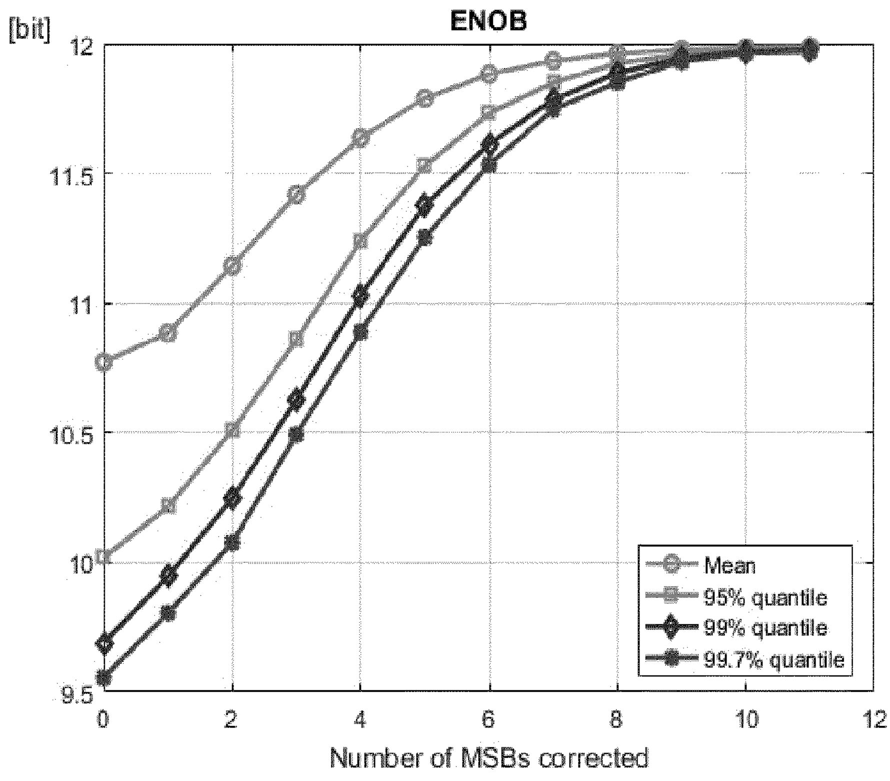
ENOB
[bit]
12
11.5
11
10.5
10
9.5
0
2
4
6
8
10
12
Number of MSBs corrected
Mean
95% quantile
99% quantile
99.7% quantile

Fig. 5A

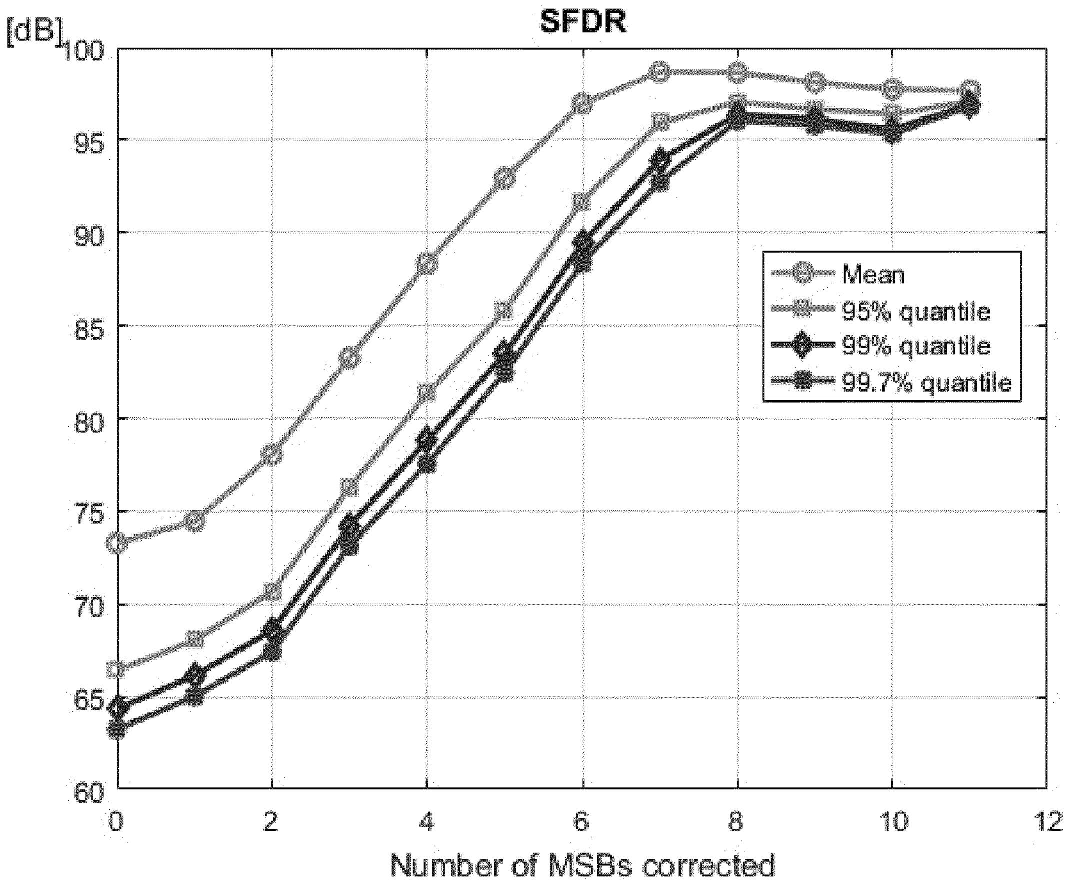
SFDR
[dB]
100
95
90
85
80
75
70
65
60
0
2
4
6
8
10
12
Number of MSBs corrected
Mean
95% quantile
99% quantile
99.7% quantile

Fig. 5B

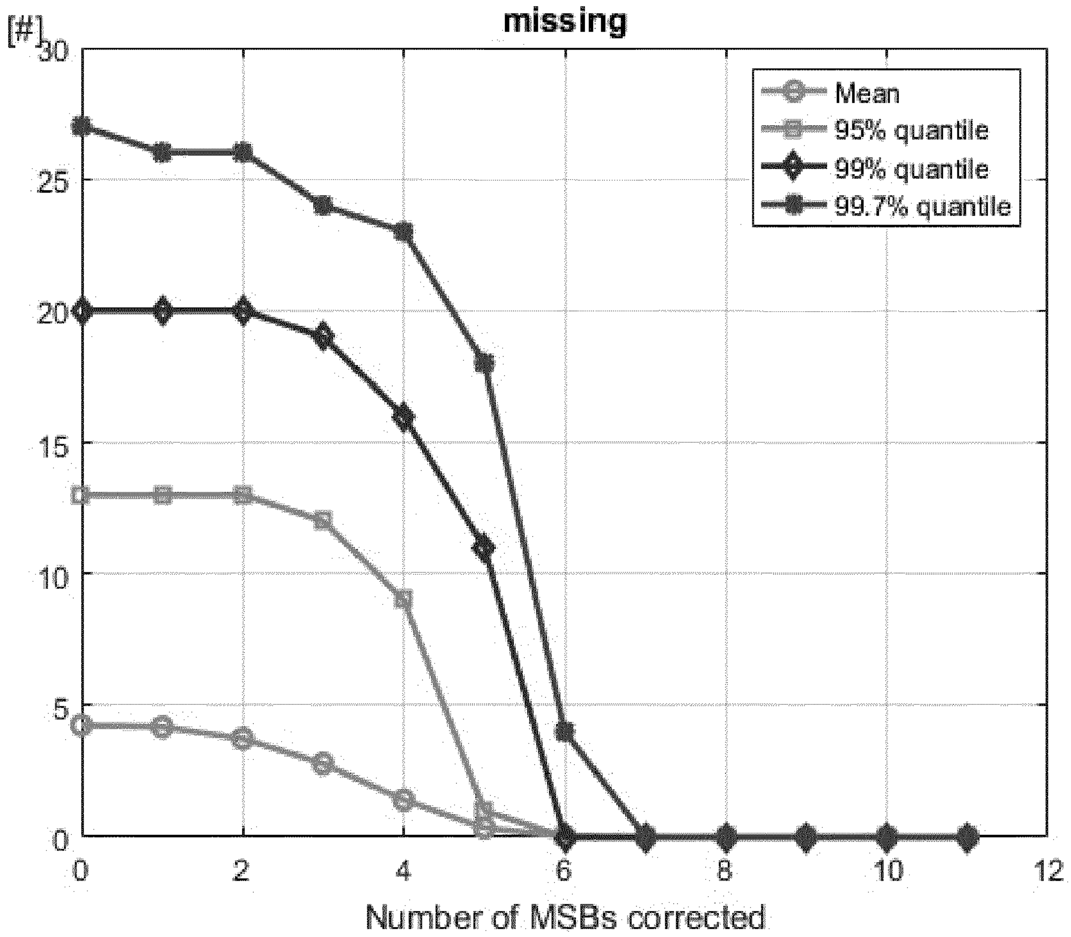
missing
[#]
30
25
20
15
10
5
0
0
2
4
6
8
10
12
Number of MSBs corrected
Mean
95% quantile
99% quantile
99.7% quantile

Fig. 6

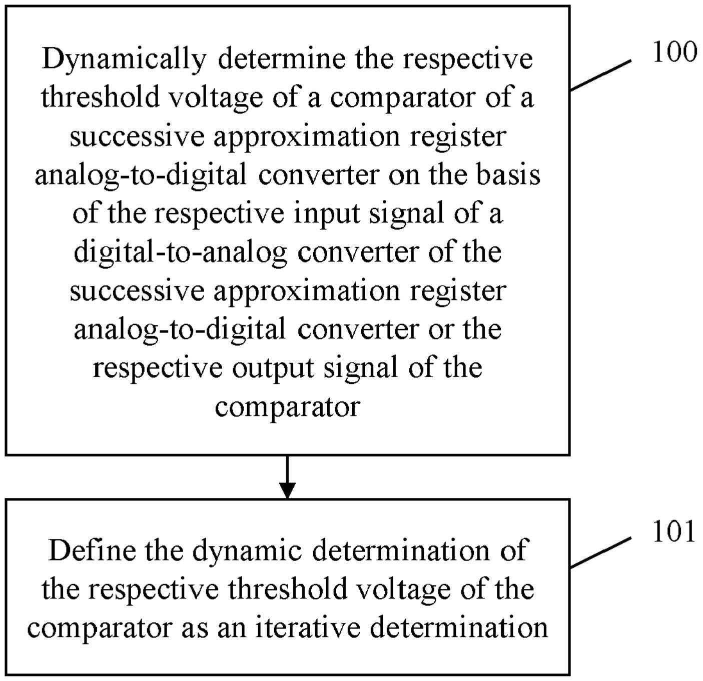
Dynamically determine the respective threshold voltage of a comparator of a successive approximation register analog-to-digital converter on the basis of the respective input signal of a digital-to-analog converter of the successive approximation register analog-to-digital converter or the respective output signal of the comparator
100
Define the dynamic determination of the respective threshold voltage of the comparator as an iterative determination
101

Fig. 7

Europäisches Patentamt
European Patent Office
Office européen des brevets

# EUROPEAN SEARCH REPORT

Application Number
EP 20 17 2006

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MAVROGORDATOS THEMISTOKLIS G ET AL: "A hybrid CDAC - threshold configuring SAR ADC in 28nm FDSOI CMOS", 2017 15TH IEEE INTERNATIONAL NEW CIRCUITS AND SYSTEMS CONFERENCE (NEWCAS), IEEE, 25 June 2017 (2017-06-25), pages 213-216, XP033141939, DOI: 10.1109/NEWCAS.2017.8010143 [retrieved on 2017-08-11] * Title * * page 214, left-hand column * * Section II * * figures 1-3 * | 1-15 | INV. H03M1/10<br>ADD. H03M1/46 |
| X | YOSHIOKA KENTARO ET AL: "An 8b extremely area efficient threshold configuring SAR ADC with source voltage shifting technique", 2014 19TH ASIA AND SOUTH PACIFIC DESIGN AUTOMATION CONFERENCE (ASP-DAC), IEEE, 20 January 2014 (2014-01-20), pages 31-32, XP032570071, DOI: 10.1109/ASPDAC.2014.6742859 [retrieved on 2014-02-18] * Title * * abstract * * page 31, left-hand column, paragraph 5 * * figures 1,3 * | 1-10, 13-15 | |
| | -/-- | | TECHNICAL FIELDS SEARCHED (IPC)<br>H03M |

The present search report has been drawn up for all claims

| Place of search | Date of completion of the search | Examiner |
|---|---|---|
| The Hague | 19 October 2020 | Rocha, Daniel |

2

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

page 1 of 2

Europäisches Patentamt
European Patent Office
Office européen des brevets

# EUROPEAN SEARCH REPORT

Application Number
EP 20 17 2006

| DOCUMENTS CONSIDERED TO BE RELEVANT | | | |
|---|---|---|---|
| Category | Citation of document with indication, where appropriate, of relevant passages | Relevant to claim | CLASSIFICATION OF THE APPLICATION (IPC) |
| X | KENTARO YOSHIOKA ET AL: "An 8bit 0.35 0.8V 0.5 30MS/s 2bit/step SAR ADC with wide range threshold configuring comparator", ESSCIRC (ESSCIRC), 2012 PROCEEDINGS OF THE, IEEE, 17 September 2012 (2012-09-17), pages 381-384, XP032466551, DOI: 10.1109/ESSCIRC.2012.6341365 ISBN: 978-1-4673-2212-6 * Title * * page 382, left-hand column, paragraph 1 * * Section III.A * * figure 2 * ----- | 1-8, 10-14 | |
| | | | TECHNICAL FIELDS SEARCHED (IPC) |

The present search report has been drawn up for all claims

| Place of search | Date of completion of the search | Examiner |
|---|---|---|
| The Hague | 19 October 2020 | Rocha, Daniel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

2

EPO FORM 1503 03.82 (P04C01)

page 2 of 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20190131991 A1